# EUROPÄISCHE PATENTSCHRIFT

(11) **EP 1 088 311 B1**
(45) Veröffentlichungstag und Bekanntmachung des Hinweises auf die Patenterteilung: **22.05.2002**
(21) Anmeldenummer: 98937408.7
(22) Anmeldetag: 24.06.1998
(51) Int. Cl.: G11C 29/00

(54) **ELEKTRONISCHE PRÜFUNGSSPEICHEREINRICHTUNG**
ELECTRONIC TEST MEMORY DEVICE
DISPOSITIF ELECTRONIQUE DE MEMORISATION UTILISE A DES FINS DE VERIFICATION

(43) Veröffentlichungstag der Anmeldung: 04.04.2001
(73) Patentinhaber: Infineon Technologies AG, 81669 München (DE)
(72) Erfinder: FIBRANZ, Heiko, D-81373 München (DE)
(74) Vertreter: Epping Hermann & Fischer
(86) Internationale Anmeldenummer: DE9801738
(87) Internationale Veröffentlichungsnummer: WO9967791

(56) Entgegenhaltungen:
- US-A- 5 177 745
- US-A- 5 596 537
- US-A- 5 615 159

## Beschreibung

Die Erfindung betrifft eine elektronische Speichereinrichtung mit elektrisch programmierbaren Speicherzellen, einem Adreßbus zum Adressieren der Speicherzellen, sowie einer steuerbaren Programmierspannungspumpe zum Erzeugen einer Programmierspannung für die Speicherzellen.

Elektronische Speichereinrichtungen dieser Art werden im allgemeinen auf einem Halbleiter-Chip realisiert, der zum Beispiel ein EEPROM-Modul (Electrically Erasable Programmable Read-Only Memory) mit einem EEPROM-Speicherfeld und der Programmierspannungspumpe sowie ein weiteres Modul mit Decodierund Logikschaltungen aufweist, mit dem die Ein- und Ausgänge des Chips verbunden sind. Das Speicherfeld stellt dabei den eigentlichen Speicher dar und umfaßt eine Anordnung aus einer Mehrzahl von Speicherzellen.

Zum Programmieren der einzelnen EEPROM-Speicherzellen muß an diese eine Programmierspannung angelegt werden, die zum Beispiel 20 V beträgt und wesentlich größer ist, als die Versorgungsspannung von zum Beispiel 5 V. Die optimale Programmierspannung wird auf dem Chip mit Hilfe der geregelten Spannungspumpe aus der Versorgungsspannung gewonnen.

Durch EP-A-0 594 294 ist eine elektronische Speichereinrichtung bekannt geworden, die elektrisch programmierbare Speicherzellen, einen Adreßbus zum Adressieren der Speicherzellen sowie eine steuerbare Programmierspannung zum Erzeugen einer Programmierspannung für die Speicherzellen aufweist.

Nach der Fertigstellung eines solchen Halbleiter-Chips muß unter anderem der EEPROM-Speicher auf seine Funktionsfähigkeit getestet werden. Hierfür sind spezielle Programmierbefehle vorgesehen, mit denen das Speicherfeld programmiert wird.

Bei einem dieser Tests wird die Programmierspannung zum Beispiel auf einen bestimmten Wert abgesenkt, um zu überprüfen, ob die Speicherzellen bei dieser Programmierspannung gerade noch nicht umprogrammiert werden.

Diese Programmierspannung wird von außen über ein zusätzliches Testpad in den Halbleiter-Chip eingespeist. Dieses Testpad ist jedoch zum normalen Betrieb der Speichereinrichtung nicht erforderlich und nimmt Chipfläche ein, die für eine Vergrößerung der Speicherkapazität nicht zur Verfügung steht bzw. macht den Chip größer als es eigentlich notwendig wäre.

Der Erfindung liegt deshalb die Aufgabe zugrunde, eine elektronische Speichereinrichtung der eingangs genannten Art zu schaffen, bei der zur Durchführung der Funktionstests des Speichers das genannte Testpad nicht erforderlich ist.

Gelöst wird diese Aufgabe gemäß Anspruch 1 dadurch, daß in der eingangs genannten elektronischen Speichereinrichtung eine mit einem Testmodesignal betätigbare Schalteinrichtung vorgesehen ist, mit der der Adreßbus in einem Testmode in der Weise an die Programmierspannungspumpe anlegbar ist, daß mittels zugeführter Adreßbits eine vorgebbare Test-Programmierspannung einstellbar ist.

Ein Vorteil dieser Lösung besteht darin, daß durch die Verwendung der Adreßbits in der Befehlsstruktur des Chips kein zusätzlicher Aufwand im Befehlsdecoder oder der Steuerlogik notwendig ist, um der Programmierspannungspumpe die Sollgröße zu übermitteln.

Ferner ist in dem Fall, in dem sicherheitskritische Daten in dem Speicher gespeichert werden, einem möglichen Angreifer durch das Fehlen des Testpads ein Angriffspunkt genommen. Die Testbefehle können fest im Chip verriegelt werden, bevor dieser die Fabrik verläßt, so daß Manipulationen nicht mehr möglich sind.

Schließlich erfordert die Speichereinrichtung weniger Platz auf dem Chip, so daß bei gleichen Abmessungen die Speicherdichte des Chips erhöht oder der Chip bei gleicher Speicherkapazität verkleinert werden kann.

Die Unteransprüche haben vorteilhafte Weiterbildungen der Erfindung zum Inhalt.

Danach ist als Test-Programmierspannung insbesondere eine Spannung vorgebbar, bei der die Speicherzellen im fehlerfreien Zustand gerade noch nicht umprogrammierbar sind.

Die Speicherzellen bilden vorzugsweise ein EEPROM-Speicherfeld. Es sind jedoch auch andere Speichertypen möglich, bei denen eine Programmierspannung zum Verändern des Speicherinhaltes erforderlich ist und zu Testzwecken variiert werden muß.

Weiterhin ist die vorgebbare Test-Programmierspannung im Testmode vorzugsweise über einen Programmierbefehl einstellbar.

Die Schalteinrichtung kann insbesondere ein Multiplexer sein.

Die Programmierspannungspumpe ist im allgemeinen geregelt, so daß mit den Adreßbits im Testmode eine Sollgröße für die Test-Programmierspannung vorgebbar ist.

Weitere Einzelheiten, Merkmale und Vorteile der Erfindung ergeben sich aus der nachfolgenden Beschreibung einer bevorzugten Ausführungsform der Erfindung anhand der Zeichnung. Es zeigt:
- Fig. 1: ein Prinzipschaltbild einer solchen Ausführungsform und
- Fig. 2a und 2b: die Struktur verschiedener Befehle zum Anlegen an die Schaltung gemäß Figur 1.

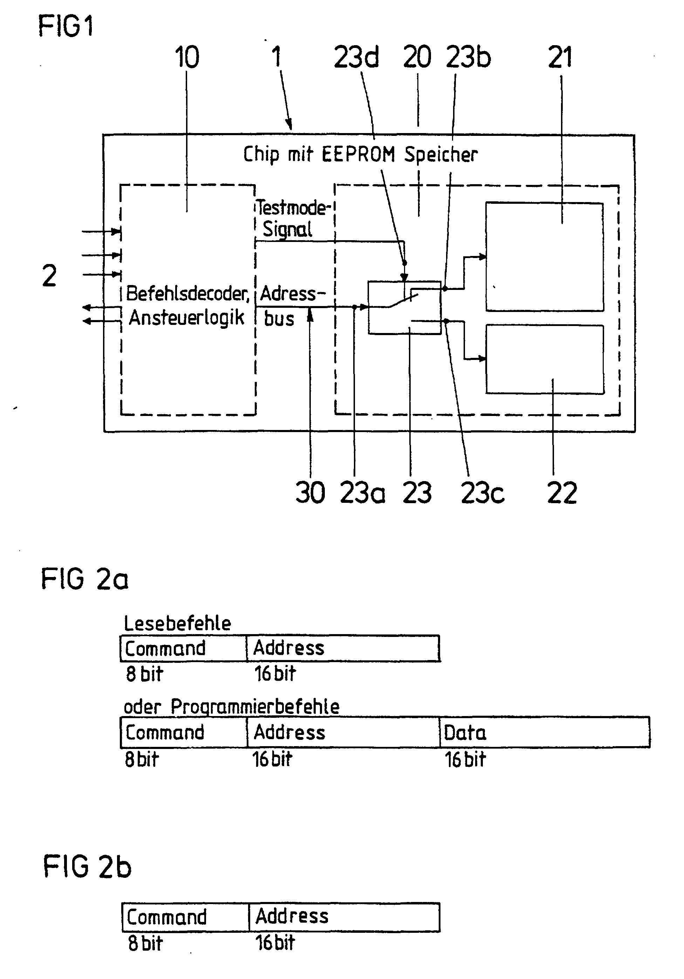

Eine elektronische Speichereinrichtung 1 mit Ein- und Ausgängen 2 weist gemäß Figur 1 ein erstes Schaltungsmodul 10, ein zweites Schaltungsmodul 20, sowie einen die beiden Schaltungsmodule verbindenden Adreßbus 30 auf.

Das erste Schaltungsmodul 10 umfaßt einen Befehlsdecoder und Schaltungen für die Ansteuerlogik. Ferner sind mit diesem Modul die Ein- und Ausgänge 2 der Speichereinrichtung 1 verbunden.

Das zweite Schaltungsmodul 20 weist ein Speicherfeld 21 mit einer Mehrzahl von einzelnen Speicherzellen, eine Programmierspannungspumpe mit Regelung 22 sowie einen Multiplexer 23 auf, an dessen Eingang 23a der Adreßbus 30 anliegt. Der Multiplexer 23 hat zwei Ausgänge 23b, 23c, von denen einer mit dem Speicherfeld 21 und der andere mit der Programmierspannungspumpe 22 verbunden ist. Der Multiplexer 23 erfüllt die Funktion eines Umschalters des an seinem Eingang 23a anliegenden Adreßbusses 30 zwischen dem Speicherfeld 21 und der Programmierspannungspumpe 22. Der Umschaltvorgang wird mit einem an einen Steuereingang 23d geführten Testmodesignal gesteuert.

Nach der Fertigstellung einer solchen elektronischen Speichereinrichtung 1 ist eine Prüfung auf fehlerfreie Funktionsfähigkeit erforderlich. Insbesondere muß gewährleistet sein, daß die Speicherzellen erst bei Erreichen einer vorgegebenen Programmierspannung und nicht schon bei einer wesentlich darunter liegenden Spannung umprogrammiert werden. Dadurch bestünde nämlich die Gefahr einer unbeabsichtigte Änderung der Inhalte der Speicherzellen, wenn zum Beispiel die Versorgungsspannung einmal aufgrund unvorhergesehener Umstände ansteigt. Mit einem entsprechenden Test wird die Programmierspannung auf einen bestimmten Wert abgesenkt, um zu überprüfen, ob sich die Speicherzellen bei dieser Spannung gerade noch nicht umprogrammieren lassen. Da mit diesem Test alle Speicherzellen auf einmal untersucht werden, brauchen sie nicht adressiert zu werden.

Zur Durchführung des Testes wird deshalb der Multiplexer 23 über seinen Steuereingang 23d mit dem Testmodesignal angesteuert, so daß der Adreßbus 30 nun an dem zweiten, mit der Programmierspannungspumpe 22 verbundenen Ausgang 23c anliegt. Anschließend wird die Programmierspannung über den Adreßbus 30 auf den vorbestimmten Wert abgesenkt, wobei die Adreßbits direkt in den Regelkreis der Programmierspannungspumpe 22 eingreifen und die neue Sollgröße für die abgesenkte Programmierspannung vorgeben. Schließlich wird der Multiplexer 23 wieder zurückgeschaltet, und die Speicherzellen können auf eine Veränderung ihrer Inhalte untersucht werden.

Die Einstellung der Programmierspannung läßt sich in einfacher Weise in die Befehlsstruktur des Chips implementieren.

Bei einer in Figur 2a gezeigten, an sich bekannten Struktur der Lese- und Programmierbefehle mit Befehls- (Command-), Adreß- und Datenteil kann der Programmierbefehl im Testmode die in Figur 2b gezeigte Form haben. Die Bits 8 bis 15 des Adreßteils dienen dabei zum Beispiel zum Einstellen der Test-Programmierspannung, während die Bits 0 bis 7 des Befehlsteils (Command) für weitere Testmode-Einstellungen genutzt oder mit "don't care" bewertet werden können.

## Patentansprüche

1. Elektronische Speichereinrichtung mit elektrisch programmierbaren Speicherzellen, einem Adreßbus zum Adressieren der Speicherzellen, sowie einer steuerbaren Programmierspannungspumpe zum Erzeugen einer Programmierspannung für die Speicherzellen,
**gekennzeichnet durch**
eine mit einem Testmodesignal betätigbare Schalteinrichtung (23), mit der der Adreßbus (30) in einem Testmode in der Weise an die Programmierspannungspumpe (22) anlegbar ist, daß mittels zugeführter Adreßbits eine vorgebbare Test-Programmierspannung einstellbar ist.

2. Elektronische Speichereinrichtung nach Anspruch 1,
**dadurch gekennzeichnet, daß**
als Test-Programmierspannung eine Spannung vorgebbar ist, bei der die Speicherzellen im fehlerfreien Zustand gerade noch nicht umprogrammierbar sind.

3. Elektronische Speichereinrichtung nach Anspruch 1 oder 2,
**dadurch gekennzeichnet, daß**
die Speicherzellen ein EEPROM-Speicherfeld (21) bilden.

4. Elektronische Speichereinrichtung nach einem der vorhergehenden Ansprüche,
**dadurch gekennzeichnet, daß**
die vorgebbare Test-Programmierspannung im Testmode über einen Programmierbefehl einstellbar ist.

5. Elektronische Speichereinrichtung nach einem der vorhergehenden Ansprüche,
**dadurch gekennzeichnet, daß**
die Schalteinrichtung ein Multiplexer (23) ist.

6. Elektronische Speichereinrichtung nach einem der vorhergehenden Ansprüche,
**dadurch gekennzeichnet, daß**
die Programmierspannungspumpe (22) geregelt ist und daß mit den Adreßbits im Testmode eine Sollgröße für die Test-Programmierspannung vorgebbar ist.

7. Elektronische Speichereinrichtung nach einem der vorhergehenden Ansprüche,
**dadurch gekennzeichnet, daß**
die im Testmode zugeführten Adreßbits als Bestandteil eines oder mehrerer Test-Programmierbefehle in der Speichereinrichtung gespeichert und bei Bedarf ausführbar sind.

## Claims

1. Electronic memory device containing electrically programmable memory cells, an address bus for addressing the memory cells, and a controllable programming-voltage pump for generating a programming voltage for the memory cells,
**characterized by**
a switching device (23) that can be actuated by a test-mode signal, and which can be used in a test mode to connect the address bus (30) to the programming-voltage pump (22) in such a way that a definable test programming voltage can be set by means of the address bits that are supplied.

2. Electronic memory device according to Claim 1,
**characterized in that**
a voltage can be defined as a test programming voltage at which the memory cells still just cannot be reprogrammed if in perfect condition.

3. Electronic memory device according to Claim 1 or 2,
**characterized in that**
the memory cells form an EEPROM memory array (21).

4. Electronic memory device according to one of the preceding claims,
**characterized in that**
the definable test programming voltage can be set in test mode via a programming command.

5. Electronic memory device according to one of the preceding claims,
**characterized in that**
the switching device is a multiplexer (23).

6. Electronic memory device according to one of the preceding claims,
**characterized in that**
the programming-voltage pump (22) is controlled and **in that** a setpoint value for the test programming voltage can be defined in test mode using the address bits.

7. Electronic memory device according to one of the preceding claims,
**characterized in that**
the address bits supplied in test mode are saved in the memory device as an element of one or more test programming commands, and can be implemented when required.

## Revendications

1. Dispositif électronique de mémorisation comportant des cellules de mémorisation programmables électriquement, un bus d'adresse pour adresser les cellules de mémoire, ainsi qu'une pompe de tension de programmation commandée pour générer une tension de programmation pour les cellules de mémoire,
**caractérisé par** un dispositif de commutation (23), qui peut être actionné par un signal de test et au moyen duquel le bus d'adresse (30) peut être appliqué en mode test à la pompe de tension de programmation (22) de telle façon qu'une tension de programmation de test prédéterminée est réglable au moyen des binaires d'adresse amenés.

2. Dispositif électronique de mémorisation selon la revendication 1, **caractérisé en ce qu'**il peut être prédéterminé comme tension de programmation de test une tension à laquelle les cellules de mémoire ne peuvent justement plus être reprogrammées à l'état sans défaut.

3. Dispositif électronique de mémorisation selon la revendication 1 ou 2, **caractérisé en ce que** les cellules de mémoire forment une zone de mémoire EEPROM (21).

4. Dispositif électronique de mémorisation selon l'une des revendications précédentes, **caractérisé en ce que** la tension de programmation de test peut être réglée en mode test par une instruction de programmation.

5. Dispositif électronique de mémorisation selon l'une des revendications précédentes, **caractérisé en ce que** le dispositif de commutation est un multiplexeur (23).

6. Dispositif électronique de mémorisation selon l'une des revendications précédentes, **caractérisé en ce que** la pompe de tension de programmation (22) est. régulée et qu'une grandeur de consigne peut être prescrite pour la tension de programmation de test avec les binaires d'adresse.

7. Dispositif électronique de mémorisation selon l'une des revendications précédentes, **caractérisé en ce que** les binaires d'adresse amenées en mode test peuvent être mémorisés comme faisant partie d'une ou de plusieurs instructions de programmation de test dans le dispositif de mémorisation et peuvent être utilisés selon le besoin.
